# EUROPEAN PATENT SPECIFICATION

(11) **EP 0 426 185 B1**
(45) Date of publication and mention of the grant of the patent: **08.03.2000**
(21) Application number: 90120982.5
(22) Date of filing: 02.11.1990
(51) Int. Cl.: G06F 11/14, G06F 11/10

(54) **Data redundancy and recovery protection**
Schutz von Datenredundanz und -rückgewinnung
Protection de récupération et redondance de données

(30) Priority: 03.11.1989 US 431741
(43) Date of publication of application: 08.05.1991
(73) Proprietor: Compaq Computer Corporation, Houston Texas 77070 (US)
(72) Inventor: Schultz, Stephen M., Houston, Texas 77070 (US); Schmenk, David S., The Woodlands, Texas 77381 (US); Flower, David L., Tomball, Texas 77375 (US); Neufeld, David E., Tomball, Texas 77375 (US)
(74) Representative: Klunker . Schmitt-Nilson . Hirsch

(56) References cited:
- WO-A-89/10594
- ELECTRONICS vol. 62, no. 2, February 1989, HASBROUCK HEIGHTS, NJ, USA pages 97 - 100 , XP000186372 T. MANUEL 'BREAKING THE DATA-RATE LOGJAM WITH ARRAYS OF SMALL DISK DRIVES'
- COMPCON 89, DIGEST OF PAPERS 27 March 1989, SAN FRANCISCO, CA, USA pages 143 - 146 , XP000093975 W.E. MEADOR 'DISK ARRAY SYSTEMS'
- COMPUTER ARCHITECTURE NEWS vol. 17, no. 5, September 1989, NEW YORK, US pages 24 - 31 , XP000083994 R.H. KATZ ET AL. 'A Project on High Performance I/O Subsystems'
- ACM SIGMOD CONFERENCE PROCEEDINGS June 1988, CHICAGO, USA pages 109 - 116 D.A. PATTERSON ET AL. 'A Case for Redundant Arrays of Inexpensive Disks (RAID)'

## Description

The present invention relates to the control of multiple disk drives within computer systems and more particularly to a method for maintaining data redundancy and recovering data stored on a disk in an intelligent mass storage disk drive array subsystem for a personal computer system.

Microprocessors and the personal computers which utilize them have become more powerful over the recent years. Currently available personal computers have capabilities easily exceeding the mainframe computers of 20 to 30 years ago and approach the capabilities of many computers currently manufactured. Microprocessors having word sizes of 32 bits wide are now widely available, whereas in the past 8 bits was conventional and 16 bits was common.

Personal computer systems have developed over the years and new uses are being discovered daily. The uses are varied and, as a result, have different requirements for various subsystems forming a complete computer system. Because of production volume requirements and the reduced costs as volumes increase, it is desirable that as many common features as possible are combined into high volume units. This has happened in the personal computer area by developing a basic system unit which generally contains a power supply, provisions for physically mounting the various mass storage devices and a system board, which in sturn incorporates a microprocessor, microprocessor related circuitry, connectors for receiving circuit boards containing other subsystems, circuitry related to interfacing the circuit boards to the microprocessor, and memory. The use of connectors and interchangeable circuit boards allows subsystems of the desired capability for each computer system to be easily incorporated into the computer system. The use of interchangeable circuit boards necessitated the developement of an interface or bus standard so that the subsystems could be easily designed and problems would not result from incompatible decisions by the system unit designers and the interchangeable circuit board designers.

The use of interchangeable circuit boards and an interface standard, commonly called a bus specification because the various signals are provided to all the connectors over a bus, was incorporated into the original International Business Machines Corporations (IBM) personal computer, the IBM PC. The IBM PC utilized in Intel Corporation 8088 as the microprocessor. The 8088 has an 8 bit, or 1 byte, external data interface but operates on a 16 bit word internally. The 8088 has 20 address lines, which means that it can directly address a maximum of 1 Mbyte of memory. In addition, the memory components available for incorporation in the original IBM PC were relatively slow and expensive as compared to current components. The various subsystems such as video output units or mass storage units, were not complex and also had relatively low performance levels because of the relative simplicity of the devices available at a reasonable costs at that time.

With these various factors and the component choices made in mind, an interface standard was developed and used in the IBM PC. The standard utilized 20 address lines and 8 data lines, had individual lines to indicate input or output (I/O) space or memory space read/write operations, and had limited availability of interrupts and direct smemory access (DMA) channels. The complexity of the available components did not require greater flexibility or capabilities of the interface standard to allow the necessary operations to occur. This interface standard was satisfactory for a number of years.

As is inevitable in the computer and electronics industry, capabilities of the various components available increased dramatically. Memory component prices dropped in capacities and speeds increased. Performance rate and capacities of the mass storage subsystems increased, generally by the incorporation of hard disk units for previous floppy disk units. The video processor technology improved so that high resolution color systems were reasonably affordable. These developments all pushed the capabilities of the existing IBM PC interface standard so that the numerous limitations in the interface standard became a problem. With the introduction by Intel Corporation of the 80286, IBM developed a new, more powerful personal computer called the AT. The 80286 has a 16 bit data path and 24 address lines so that it can directly address 16 Mbytes of memory. In addition, the 80286 has an increased speed of operation and can easily perform many operations which taxed 8088 performance limits.

It was desired that the existing subsystem circuit boards be capable of being used in the new AT, so the interface standard used in the PC was utilized and extended. A new interface standard was developed, which has become known as the industry standard architecture (ISA). A second connector for each location was added to contain additional lines for the signals used in the extension. These lines included additional address and data lines to allow the use of the 24 bit addressing capability and 16 bit data transfers, additional interrupt and direct memory access lines and lines to indicate whether the subsystems circuit board was capable of using the extended features. While the address values are spresented by the 80286 microprocessor relatively early in the operation cycle, the PC interface standard could not utilize the initial portions of the address availability because of different timing standards for the 8088 around which the PC interface was designed. This limited the speed at which operations could occur because they were now limited to the interface standard memory timing specifications and could not operate at the rates available with the 80286. Therefore, the newly added address lines included address signals previous available, but the newly added signals were available at an early time in the cycle. This change in the address single timing allowed operations which utilized the extended portions of the architecture to operate faster.

With a higher performance components available, it became possible to have a master unit other than the system microprocessor or direct memory access controller operating the bus. Bowever, because of the need to cooperate with circuit boards which operated under the new 16 bit standard or the old 8 bit standard, each master unit was required to understand and operate with all the possible combinations of circuit boards. This increased the complexity of the master unit and resulted in a duplication of components, because the master unit had to incorporate many of the functions and features already performed by the logic and circuitry on the system board and other master units. Additionally, the master unit was required to utilize the direct memory access controller to gain control of the bus, limiting prioritizing and the number of master units possible in a given computer system.

The capability of components continued to increase. Memory speeds and sizes increased, mass storage units and size increased, video unit resolutions increased and Intel Corporation introduced the 80386. The increased capabilities of the components created a desire for the use of master units, but the performance of a master unit was limited by the ISA specification and capabilities The 80386 could not be fully utilized because it offered the capability to directly address 4 Gbytes of memory using 32 bits of address and could perform 32 bit wide data transfers, while the ISA standard allowed only 16 bits of data and 24 bits of address. The local area network (LAN) concept, where information and file stored on one computer called server and distributed to local work stations having limited or no mass storage capabilities, started becoming practical with the relatively low cost of high capability of components needed for adeguate servers and the low costs of the components for work stations. An extension similar to that performed in developing the ISA could be implemented to utilize the 80386's capabilities. However, this type of extension would have certain disadvantages. With the advent of the concept and the high performance requirements of the server and of video graphics work stations used in computeradded design and animation work, the need for a very high data transfer rates became critical. An extension similar to that performed in developing the ISA would not provide this capability, even if slightly shorter standards cycle was provided, because this would still leave the performance below desired levels.

With the increased performance of computer systems, it became apparent that mass storage subsystems, such as fixed disk drives, played an increasingly important role in the transfer data to and from the computer system. In the past few years, a new trend in storage subsystems has emerged for improving data transfer performance, capacity and reliability. This is generally known as a disk array subsystem. One key reason for wanting to build a disk array subsystem is to create a logical device that has very high data transfer rate. This may be accomplished by "ganging" multiple standard disk drives together and transferring data to or from these drives to the system memory. If n drives are ganged together, then the effective data transferred rate is increased n times. This technique, called "striping" originated in the super computing environment where the transfer of large amounts of data to and from secondary storage is a freguent requirement. With this approach, the end physical drives would become a single logical device and may be implemented either through software or hardware.

Two data redundancy techniques have generally been used to restore data in the event of a catastrophic drive failure. One technique is that of a mirrored drive. A mirrored drive in effect creates a redundant data drive for each data drive. A write to a disk array utilizing the mirrored drive fault tolerance technique will result in a write to the primary data disk and a write to its mirror drive. This technique results in a minimum loss of performance in the disk array. However, there exist certain disadvantages to the use of mirrored drive fault tolerance tecbnigues. The primary disadvantage is that this technique uses 50% of total data storage available for redundancy purposes. This results in a relatively high cost per available storage.

Another technique is the use of a parity scheme which reads data blocks being written to various drives within the array and uses a known exclusive or (XOR) technique to create parity information which is written to a reserved or parity drive in the array. The advantage to this technique is that it may be used to minimize the amount of data storage dedicated to redundancy and data recovery purposes when compared with mirror techniques. In an 8 drive array, the parity tecbniqe would call for one drive to be used for parity information; 12.5% of total storage is dedicated to redundancy as compared to 50% using the mirror technique. The use of the parity drive technique decreases the cost of data storage. However, there exist a number of disadvantages to the use of parity fault tolerance mode. The primary among the disadvantages is the loss of performance within the disk array as the parity drive must be updated each time a data drive is updated. The data must undergo the XOR process in order to write to the parity drive as well as writing the data to the data drives.

The use of the system processor to perform XOR parity information generation requires that the drive data go from the drives to a transfer buffer, to the system processor local memory to create the XOR parity information and that the parity information be written back to the drive via the transfer buffer. As a result, the host system processor encounters significant overhead in managing the generation of the XOR parity. The use of the local processor within the disk array controller also encounters many of the same problems that a system processor would. The drive data must again go from the drives to a transfer buffer to local processor memory to generate the XOR parity information and then back to the parity drive via the transfer buffer.

Related to this field of data error correction is U.S. Patent No. 4,775,978 for data error correction system.

The document Electronics, Vol. 62, No. 2, February 1989, Hasbrock Heights, US, "Breaking the Data-Rate LOGJAM with Arrays of Small Disk Drives", pages 97-100, discloses a RAID system with error-correction code distributed across all drives, whereby failed drives can be replaced and regenerated on replacement drives without interrupting operation.

A number of reference articles on the design of disk arrays have been published in recent years. These include ltsome Design Issues of Disk Arrays" by Spencer Ng, April 1989 IEEE; "Disk Array Systems" by Wes E. Meador, April 1989 IEEE; and "A Case for Redundant Arrays of Inexpensive Disks (RAID)" by D. Patterson, G. Gibson and R. Catts report No. UCB/CSD 87/391, December 1987, Computer Science Division, University of California, Berkley, California.

In the past when a drive has failed and has been replaced, it has been necessary to request special commands and operations to restore the data to the disk. Many times these operations require the dedication of the computer system such that it is not available to system users during the rebuild process. Both of these situations create transparency problems when recovering lost data.

The present invention which comprises features contained in the appended claims is for use with a personal computer having a fault tolerant, intelligent disk array controller system; the controller being capable of managing the operation of an array of up to 8 standard integrated disk drives connected in drive pairs without supervision by the computer system host. Specifically, the present invention is directed towards a method and apparatus for maintaining data redundancy and restoring data to a failed disk within a disk array in a manner transparent to the host system and user.

The apparatus of the present invention contemplates the use of a dedicated XOR parity engine to be incorporated in the transfer controller. The parity XOR engine utilizes a disk array DMA channel which is itself composed of four individual subchannels. The XOR engine utilizes one of the subchannels, generating parity data on a word for word basis from up to four different transfer buffer blocks. Further, the XOR engine is capable of writing the result to either a specified disk drive or to a transfer buffer through the subchannel. The parity control circuitry within the transfer controller includes a 16 bit parity control register. Information with the parity control register includes: a parity enable bit which enables the disk DMA channel for parity operation; a parity direction bit which determines if the XOR result is to be placed in a transfer buffer or written to a disk; two parity count bits which are used to determine the number of data blocks that are to be XOR'd together during the parity operation; an interrupt enable bit; and a parity return bit which indicates whether a parity channel comparison was successful. The parity count operation bit refers to the number of separate transfer buffer memory ranges that are to be XOR'd together. Each of the memory ranges requires a separate starting memory address pointer.

The transfer controller parity circuitry also incorporates four 16 bit parity RAM address registers (0-3) used in conjunction with parity operations. The RAM address registers provide the starting pointers to the transfer buffer memory locations which contain the data blocks to be XOR'd together. Register 0 is assigned to the disk DMA subchannel 3, which, when enabled, is used to manage parity operations. The operation of the parity RAM address registers varies with the number of different blocks that are selected to be XOR'd together and whether the XOR result is to be written back to the transfer buffer or to the parity drive. If four separate block ranges are specified, data will be read from the blocks pointed to by the parity RAM address registers, the data will be XOR'd together and the results will be written to the block addressed by the last parity RAM register or to the parity drive. Should three separate block ranges be selected, the XOR result will be written to the memory location addressed by the parity RAM address register 2. Similarly, when two block ranges are selected, the XOR result will be written to the memory location addressed by parity RAM address register 1.

A better understanding of the invention can be had when the following detailed description of the preferred embodiment is considered in conjunction with the following drawings, in which:
Figures 1 and 2 are a schematic block diagrams of a computer system incorporating the present invention;
Figure 3 is a schematic block diagram of a disk array controller incorporating the present invention;
Figures 4A and 4B are flow diagrams depicting the loading of a disk array configuration within the present invention;
Figure 5 is a schematic block diagram depicting a command list, including command list header and request blocks;
Figure 6 is a flow diagram depicting the manner in which I/O requests are submitted to the disk array controller of the present invention;
Figure 7 is a flow diagram depicting the manner in which the present invention determines whether all drives within an array contain consistent drive parameter information;
Figure 8 is a schematic block diagram of one method of use of a parity XOR engine incorporated in the present invention;
Figure 9 is schematic block diagram showing how parity information may be generated;
Figure 10 is schematic block diagram showing the process by which a parity engine may be used to maintain a disk drive array having an excess of 4 drives in the array;
Figure 11 is a schematic block diagram depicting a manner in which the present invention may be used to recover a drive under parity fault tolerance mode;
Figure 12 is a schematic block diagram showing the method by which the XOR engine incorporated in the present invention may be used to recover data information in an 8 drive array;

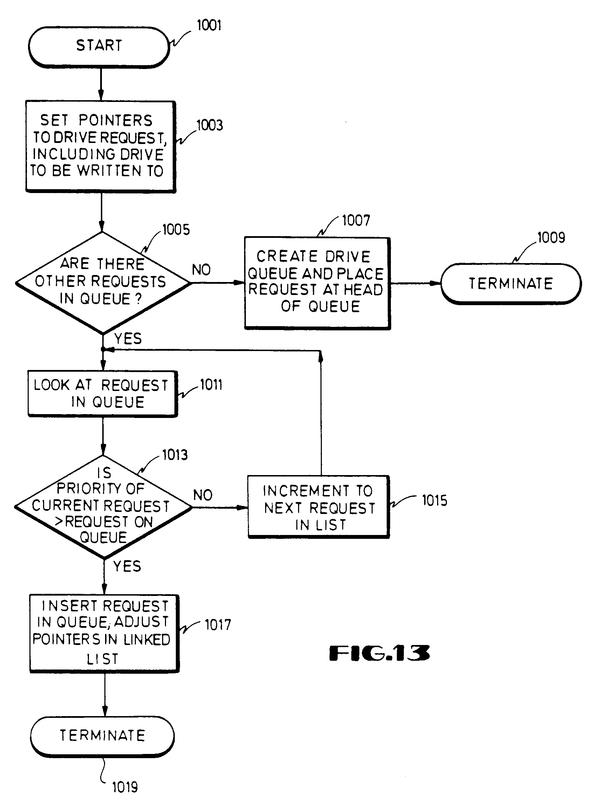

Figure 13 is a flow diagram depicting the manner in which I/O requests are submitted to the disk array controller of the present invention;
Figure 14 is a flow diagram of the REGENERATE function used to correct either a disk drive fault or to rebuild a replacement drive according to the present invention;
Figure 15 is flow diagram of the PARITY_REGEN function called by the REGENERATE function of Figure 14;;
Figure 16 is a flow diagram of the MIRROR_REGEN function called by the REGENERATE function of Figure 14;
Figure 17 is a flow diagram of the RECONSTRUCT function used to control the process of reconstructing data according to the present invention;
Figure 18 is a flow diagram of the method utilized in the BUILD_DRIVE function called by the reconstruct function; and

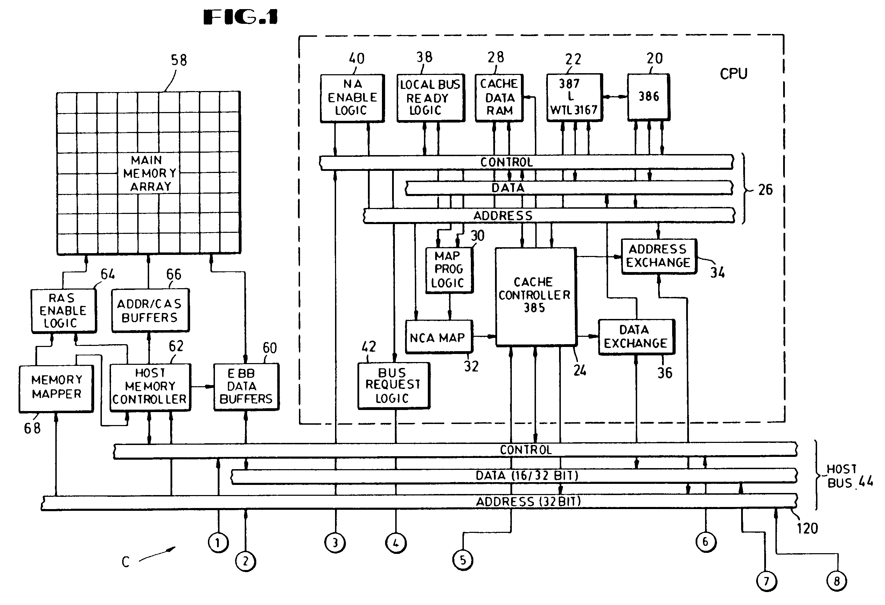

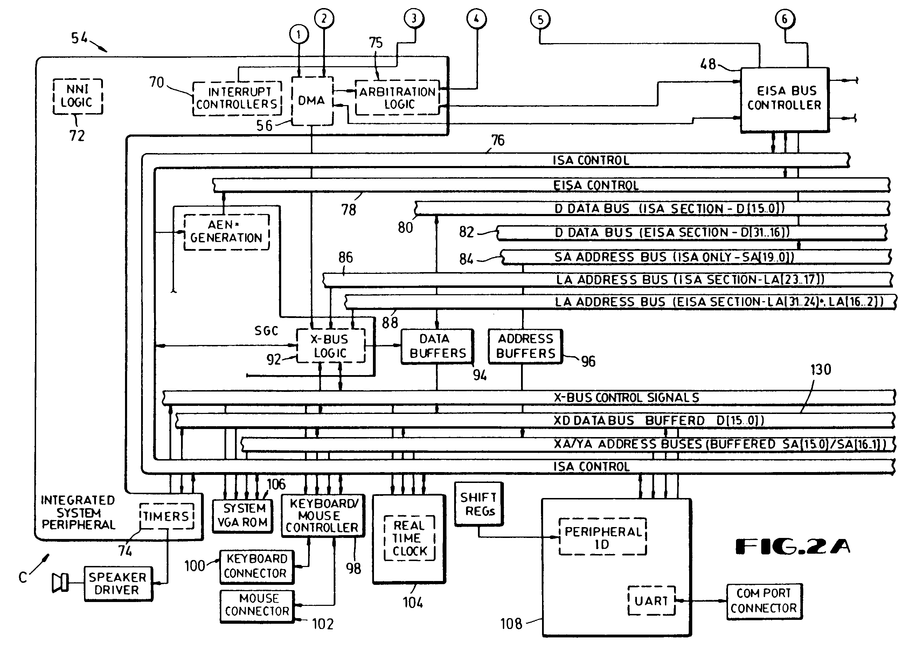

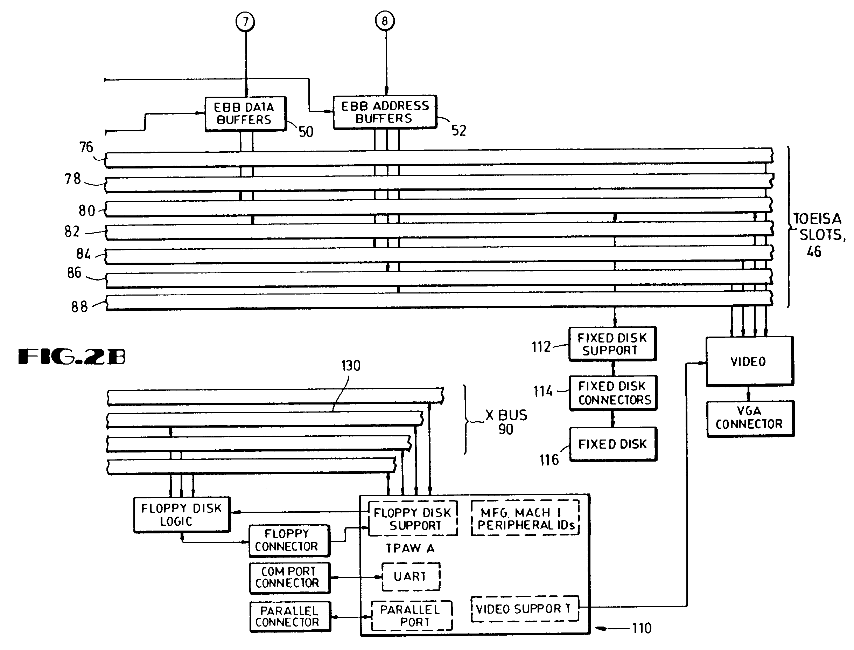

Referring now to Figures 1 and 2, the letter C designates generally a computer system incorporating the present invention. For clarity, system C is shown in two portions, with the interconnections between Figures 1 and 2 designated by reference to the circled numbers one to eight. System C is comprised of a number of block elements interconnected via four buses.

In Figure 1, a computer system C is depicted. A central processing unit CPU comprises a processor 20, a numerical coprocessor 22 and a cache memory controller 24 and associated logic circuits connected to a local processor bus 26. Associated with cache controller 24 is high speed cache data random access memory 28, noncacheable memory address map programming logic circuitry 30, noncacheable address memory 32, address exchange latch circuitry 34 and data exchange transceiver 36. Associated with the CPU also are local bus ready logic circuit 38, next address enable logic circuit 40 and bus request logic circuit 42.

The processor 20 is preferably an Intel 80386 microprocessor. The processor 20 has its control, address and data lines interfaced to the local processor bus 26. The coprocessor 22 is preferably an Intel 80387 and/or Weitek WTL 3167 numeric coprocessor interfacing with the local processor bus 26 and the processor 20 in the conventional manner. The cache ram 28 is preferably suitable high-speed static random access memory which interfaces with the address and data elements of bus 26 under control of the cache controller 24 to carry out required cache memory operations. The cache controller 24 is preferably an Intel 82385 cache controller configured to operate in two-way set associative master mode. In the preferred embodiment the components are the 33 MHz versions of the respective units. Address latch circuitry 34 and data transceiver 36 interface the cache controller 24 with the processor 20 and provide a local bus interface between the local processor bus 26 and a host bus 44.

Circuit 38 is a logic circuit which provides a bus ready signal to control access to the local bus 26 and indicate when the next cycle can begin. The enable circuit 40 is utilized to indicate that the next address of data or code to be utilized by subsystem elements in pipelined address mode can be placed on the local bus 26.

Noncacheable memory address map programmer 30 cooperates with the processor 20 and the noncacheable address memory 32 to map noncacheable memory locations. The noncacheable address memory 32 is utilized to designate areas of system memory that are noncacheable to avoid many types of cache memory incoherency. The bus request logic circuit 42 is utilized by the processor 20 and associated elements to request access to the host bus 44 in situations such as when requested data is not located in the cache memory 28 and access to system memory is required.

In the drawings, system C is configured having the processor bus 26, the host bus 44, an extended industry standard architecture (EISA) bus 46 (Fig. 2) and an X bus 90. The details of the portion of the system illustrated in Figure 2 and not discussed in detail below are not significant to the present invention other than to illustrate an example of a fully configured computer system. The EISA specification Version 3.1 is included as Appendix 1 to fully explain requirements of an EISA system. The portion of system C illustrated in Fig. 2 is essentially a configured EISA system which includes the necessary EISA bus 46, and EISA bus controller 48, data latches and transceivers 50 and address latches and buffers 52 to interface between the EISA bus 46 and the host bus 44. Also illustrated in Figure 2 is an integrated system peripheral 54, which incorporates a number of the elements used in an EISA-based computer system.

The integrated system peripheral (ISP) 54 includes a direct memory access controller 56 for controlling access to main memory 58 (Fig. 1) or memory contained in EISA slots and input/output (I/O) locations without the need for access to the processor 20. The main memory array 58 is considered to be local memory and comprises a memory circuit array of size suitable to accommodate the particular requirements of the system. The ISP 54 also includes interrupt controllers 70, nonmaskable interrupt logic 72 and system timers 74 which allow control of interrupt signals and generate necessary timing signals and wait states in a manner according to the EISA specification and conventional practice. In the preferred embodiment, processor generated interrupt request are controlled via dual interrupt control circuits emulating and extending conventional Intel 8259 interrupt controllers. The ISP 54 also includes bus arbitration logic 75 which, in cooperation with the bus controller 48, controls and arbitrates among the various requests for the EISA bus 46 by the cache controller 24, the DMA controller 56 and bus master devices located on the EISA bus 46.

The main memory array 58 is preferably dynamic random access memory. Memory 58 interfaces with the host bus 44 via a data buffer circuit 60, a memory controller circuit 62 and a memory mapper 68. The buffer 60 performs data transceiving and parity generating and checking functions. rne memory controller 62 and memory mapper 68 interface with the memory 58 via address multiplexer and column address strobe buffers 66 and row address enable logic circuit 64.

The EISA bus 46 includes ISA and EISA control buses 76 and 78, ISA and EISA control buses 80 and 82 and address buses 84, 86 and 88. System peripherals are interfaced via the X bus 90 in combination with the ISA control bus 76 from the EISA bus 46. Control and data/address transfer for the X bus 90 are facilitated by X bus control logic 92, data transceivers 94 and address latches 96.

Attached to the X bus 90 are various peripheral devices such as keyboard/mouse controller 98 which interfaces the X bus 90 with a suitable keyboard and mouse via connectors 100 and 102, respectively. Also attached to the X bus 90 are read only memory circuits 106 which contain basic operations software for the system C and for system video operations. A serial communications port 108 is also connected to the system C via the X bus 90. Floppy and fixed disk support, a parallel port, a second serial port, and video support circuits are provided in block circuit 110.

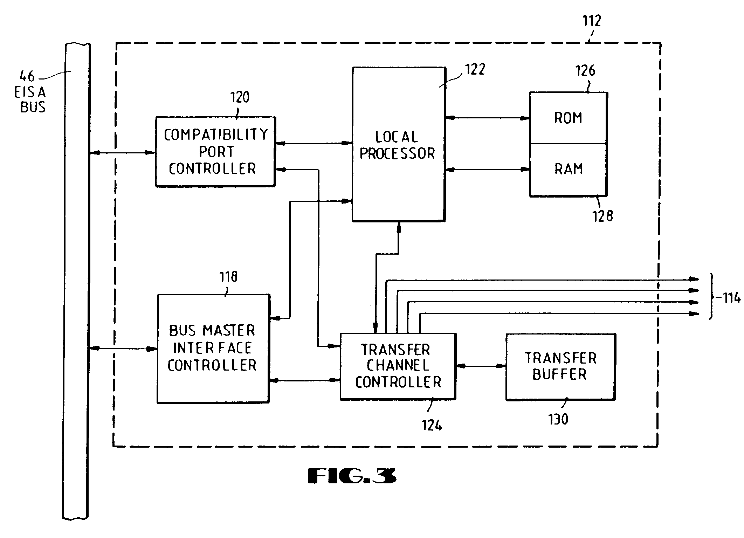

The disk array controller 112 is connected to the EISA bus 46 to provide for the communication of data and address information through the EISA bus. Fixed disk connectors 114 are connected to the fixed disk support system and are in turn connected to a fixed disk array 116. Figure 3 is a schematic block diagram of the disk array controller 112 incorporating the present invention. The disk array controller 112 incorporating the present invention includes a bus master interface controller 118 (BMIC), preferably an Intel Corporation 82355, which is designed for use in a 32 bit EISA bus master expansion board and provides all EISA control, address, and data signals necessary for transfers across the EISA bus. The BMIC 118 supports 16 and 32 bit burst transfers between the disk array system and system memory. Further, the BMIC is capable of converting a transfer to two 32 bit transfers if the memory to be transferred is nonburstable. Additionally, BMIC 118 provides for the transfers of varying data sizes between an expansion board and EISA and ISA devices.

The disk array controller 112 of the present invention also includes a compatibility port controller (CPC) 120. The CPC 120 is designed as a communication mechanism between the EISA bus 46 and existing host driver software not designed to take advantage of EISA capabilities.

Also included in the disk array controller 112 which incorporates the present invention is a microprocessor 122, preferably an Intel Corporation 80186 microprocessor. The local processor 122 has its control, address and data lines interfaced to the BMIC 118, CPC 120, and transfer channel controller 124. Further, the local processor 122 is also interfaced to local read only memory (ROM) 126 and dynamic random access memory (RAM) 128 located within the disk array controller 112.

The transfer channel controller (TCC) 124 controls the operation of four major DMA channels that access a static RAM transfer buffer 130. The TCC 124 assigns DMA channels to the BMIC 118, the CPC 120 the local processor 122 and to the disk array DMA channel 114. The TCC 124 receives requests from the four channels and assigns each channel a priority level. The local processor 122 has the highest priority level. The CPC 120 channel has the second highest priority level. The BMIC 118 channel has the third highest priority level and the disk array DMA channel 114 has the lowest priority level.

The disk array DMA channel 114 is comprised of four disk drive subchannels. The four disk drive subchannels may be assigned to any one of eight different disk drives residing in the disk array. The four drive subchannels have equal priority within the disk array DMA channel. The subchannels are rotated equally to become the source for the disk array DMA channel. One of the subchannels is inserted in rotation only if it has an active DMA request. The remaining three subchannels are always active in the rotation.

In the present invention a request is preferably submitted to the disk array controller 112 through the BMIC 118. The local processor 122 on receiving this request through the BMIC 118 builds a data structure in local processor RAM memory 128. This data structure is also known as a command list and may be a simple read or write request directed to the disk array, or it may be a more elaborate set of request containing multiple read/write or diagnostic and configuration requests. The command list is then submitted to the local processor 122 for processing. The local processor 122 then oversees the execution of the command list, including the transferring of data. Once the execution of the command list is complete, the local processor 122 notifies the operating system device driver. The submission of the command list and the notification of a command list completion are achieved by a protocol which uses the BMIC 118 I/O registers. To allow multiple outstanding requests to the disk array controller 112, these I/O registers are divided into two channels: a command list submit channel and a command list complete channel.

The method of the present invention is implemented as a number of application tasks running on the local processor 122 (Fig. 3). Because of the nature of interactive input/output operations, it is impractical for the present invention to operate as a single batch task on a local processor 122. Accordingly, the local processor 122 utilizes a real time multitasking use system which permits multiple tasks to be addressed by the local processor 122, including the present invention. Preferably, the operating system on the local processor 122 is the AMX86 Multitasking Executive by Kadak Products Limited. The operating system kernel provides a number of system services in addition to the applications set forth the method of the present invention.

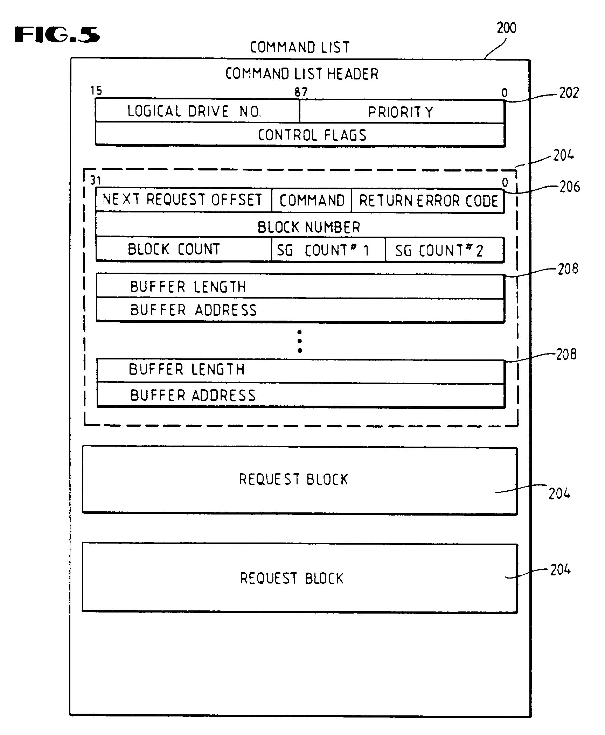

Referring now to Fig. 5, the method of the present invention includes the development of a data structure for the disk array controller 112 known as a command list 200. The command list 200 consist of a command list header 202, followed by a variable number of request blocks 204. The request blocks are variable in length and may be any combination of I/O requests which will be described further below. A command list 200 typically contains a number of related request blocks 204; from 1 to any number that take up less than 16 Kbyte of memory. The command list header 202 contains data that applies to all request blocks 204 in a given command list 200: logical drive number, priority and control flags. The request blocks 204 consist of a request block header 206 and other requested parameters, given the nature of the request. The request block header 206 has a fixed length, whereas other request parameters are variable in length.

The individual request blocks 204 each represent an individual I/O request. By forming a command list 200 out of several individual request blocks, and submitting the command list 200 to the disk array controller 112 (Fig. 2), the computer system C microprocessor 20 overhead is reduced.

Still referring to Fig. 5, a command list header 202 contains information that applies to each of the request blocks 204 contained in the command list 200. The command list header 202 is a total of 4 bytes in length. The logical drive number specifies which to logical drive that all request blocks 204 within the command list 200 apply. The method of the present invention permits a total of 256 logical drives to be specified. The priority bit is used to provide control over the processing of a command list. The disk array controller 112 is capable of operating upon many command list concurrently. In specifying priority, the method of the present invention permits a command list to be processed prior to those already scheduled for processing by the disk array controller. The control flag bytes in the method of the present invention are used for error processing and ordering of request of the same priority. Ordered request are scheduled according to priority, however, they are placed after all previous request of the same priority. If all requests are of the same priority and the order flag is set, the request are performed on a first-come, first-serve basis.

Error condition reporting options are specified by error flags in the control flag bytes. In the event of an error, the disk array controller 112 can either: notify the requesting device and continue processing request blocks 204 in the list; notify the requesting device and stop processing of all other request blocks 204 in the list; or not notify the requesting device of the error. In all instances, an error code will be returned in the command list status register at the time the next command list complete notification and in the error code field in the request block 204 where the error occurred. Further, notification of completion may be set for each individual request block 204 or for the entire command list 200. In the event the EISA bus 46 is to be notified each time a request block has been completed a "notify on completion of every request" flag may be set in the control flags field.

A command list 200 has a variable number of request blocks 204. In order to quickly and efficiently traverse the list of variable request blocks 204 the request header includes a pointer or next request offset which specifies an offset of "n" bytes from the current request block address to the next request block. This field makes the command list 200 a set of linked list request blocks 204. The last request block 204 has a value of 000h in the next request offset to signify the end of the command list 200. Thus, the method in the present invention permits memory space between request blocks 204 within a command list 200 which may be used by an operating system device driver. However, it should be noted that the greater the extra space between the request blocks 204 the longer it will require the disk array controller 112 to transfer the command list 200 into its local memory.

A request block 204 is comprised of two parts, a fixed length request header 206 any variable length parameter list 208. The parameters are created as data structures known as scatter/gather (S/G) descriptors which define system memory 58 data transfer addresses. The request header 206 fields contain a link to the next request block 204, the I/O command, space for a return status, a block address and a block count, and a count of the scatter/gather descriptor structure elements for two S/G structures. The request header is a total of 12 bytes in length.

The scatter/gather descriptor counters are used to designate the number of scatter/gather descriptors 208 which utilized in the particular request. The number of scatter/gather descriptors 208 associated with the request block 204 will vary. Further, if the command is a read command, the request may contain up to two different sets of scatter/gather descriptors. Each scatter/gather descriptor 208 contains a 32 bit buffer length and a 32 bit address. This information is used to determine the system memory data transfer address which will be the source or destination of the data transfer. Unlike the requests blocks 204 in the command list, the scatter/gather descriptors must be contiguous and, if there exists a second scatter/gather descriptor set for a request, it must directly follow the first set of scatter gather descriptors.

The command specifies the function of the particular request block and implies the format of the parameter list. The commands supported by the disk array controller 112 include:

| COMMAND |
|---|
| IDENTIFY LOGICAL DRIVE |
| IDENTIFY CONTROLLER |
| IDENTIFY LOGICAL DRIVE STATUS |
| START RECOVERY |
| READ |
| WRITE |
| DIAGNOSTIC MODE |
| SENSE CONFIGURATION |
| SET CONFIGURATION |

The start recovery command is issued by EISA CMOS and is used to initiate rebuild of a mirror drive in the instance of a mirror fault tolerance mode or parity recovery to recover lost data information for a defective or replacement disk.

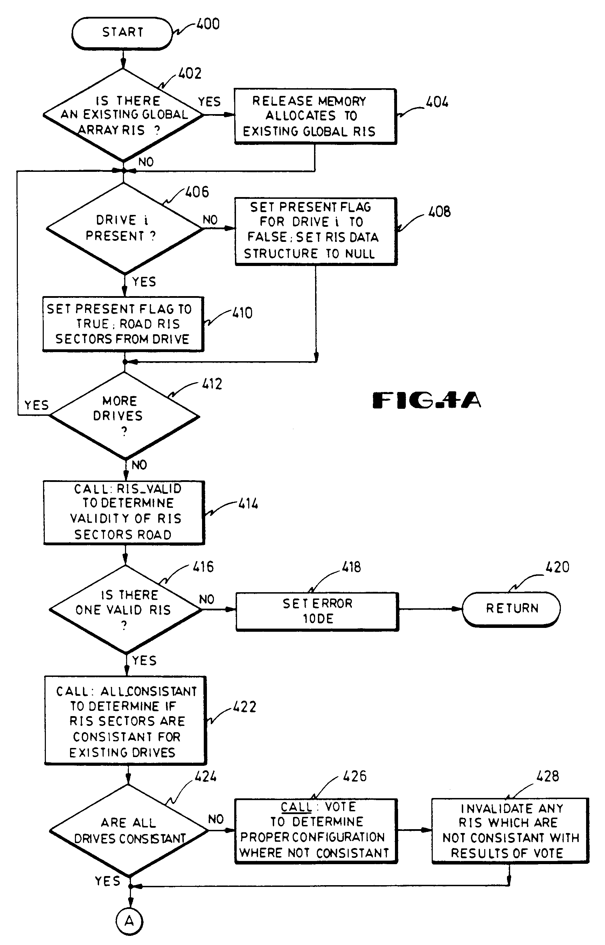

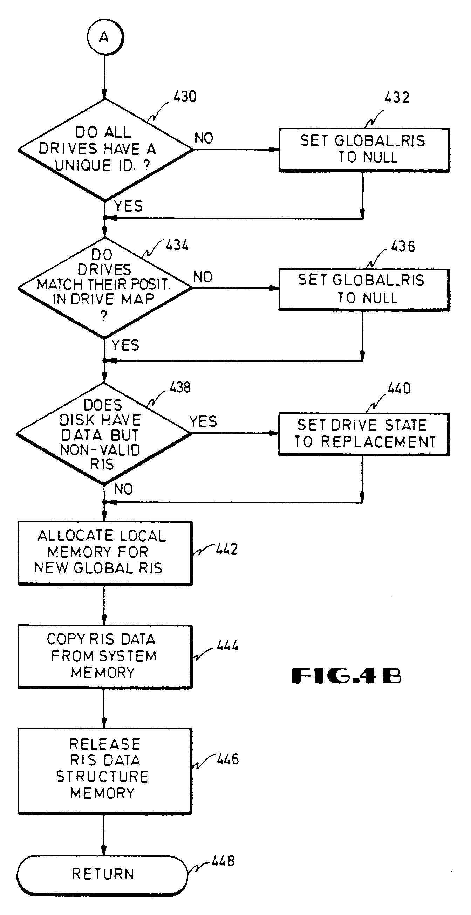

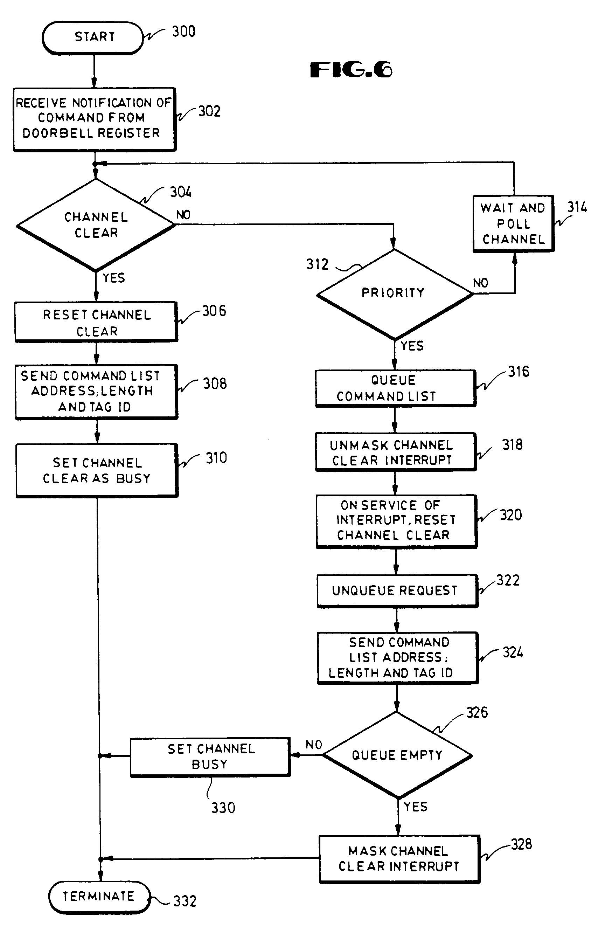

When a new command list 200 is submitted to the disk array controller 112, the system processor 20 determines if the transfer channel is clear. If the channel is busy, the system processor 20 may poll, waiting for the channel to clear, or it may unmask the channel clear interrupt so that it will be notified when the disk array controller clears the channel. Fig. 6 is a flowchart of the method used to submit a new command list 200 to the disk array controller 112. Operation of submission begins at step 300. The local processor 122 receives notification of submission a command list 200 (Fig. 4) from the doorbell register in step 302 via BMIC 118. Control transfers to step 304 where the local processor 122 determines whether the channel 0 (command submission channel) is clear. If the channel is clear, control transfers to step 306 in which the BMIC 118 resets the channel clear bit. Control transfers to step 308 which loads the command list 200 address, length and tag I.D. to the mailbox registers to be read by the local processor 122. Control transfers to step 310 in which the local processor 122 sets the channel clear bit to busy. Control transfers to step 332 which terminates the submission of the command.

If in step 304 the local processor 122 determines that the command submit channel is not clear, the local processor 122 continues to poll for channel clear. If then channel is clear, control transfers to step 304. If the local processor 122 determines in step 312 that the command list 200 submission is a priority submission, control transfers to step 316 which places in a ring queue the 4 byte command list header which points back to the command list 200 to be transferred. Control transfers to step 318 in which the local processor 122 unmasks the channel clear interrupt bit. On service of the interrupt by the local processor 122, control transfers to step 320 which resets the channel clear. Control transfers to step 322 where the local processor 122 dequeues the command list header and transfers the command list 200 to the BMIC registers. Control transfers to step 324 which loads the command list address, length and tag I.D. into the channel registers. Control transfers to step 326 which determines whether the command list submission queue is empty. If the command list submission list queue is empty, control transfers to step 328 in which the local processor 122 masks the channel clear interrupt bit. Control transfers to step 332 which terminates the command list submission. If the local processor determines in step 326 that the queue is not empty, control transfers to step 330 which sets the channel busy bit. Control is then transferred to step 332 which terminates the submission of the command list.

The use of a parity fault tolerance scheme in a disk array is depicted in a series of block diagrams depicting various steps in the process. It should be noted that the block diagrams are used solely to depict various methods of using parity fault tolerance. The reference to the TCC 124 in the block diagram is meant to refer both to the dedicated XOR parity engine incorporated in the TCC 124 and the disk DMA subchannel 3 used by the XOR parity engine in reading and writing parity data.

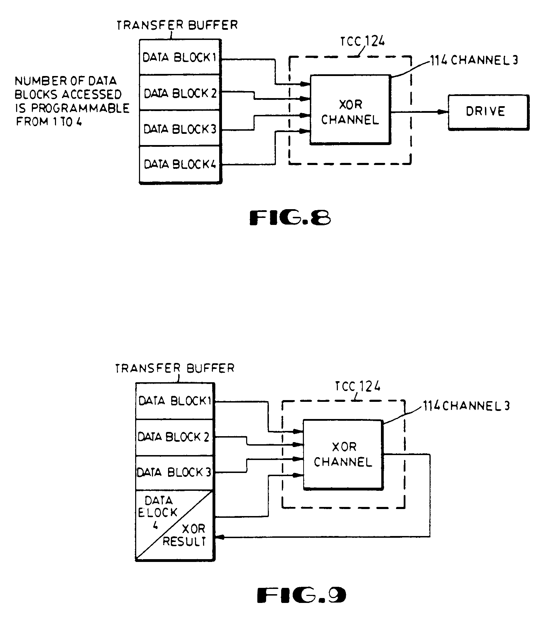

Figure 8 is schematic block diagram of the manner in which the parity XOR engine incorporated into TCC 124 generates parity information to be written to the parity drive within an array. Figure 8 depicts four different data blocks within a transfer buffer being read by the parity engine which is enabled on disk DMA channel 114 subchannel 3. The parity information is generated by the XOR engine by performing successive XOR operations on the data from the same relative location of each data block. The resulting parity information is written to the parity drive within the logical unit. Alternately, the parity information may be written back to the last transfer buffer as depicted in Figure 9. In Figure 9, data blocks 1-4 are read by the TCC 124 parity engine through disk DMA channel 114 subchannel 3. The parity information is generated by the XOR engine and is written back to the transfer buffer as a XOR result.

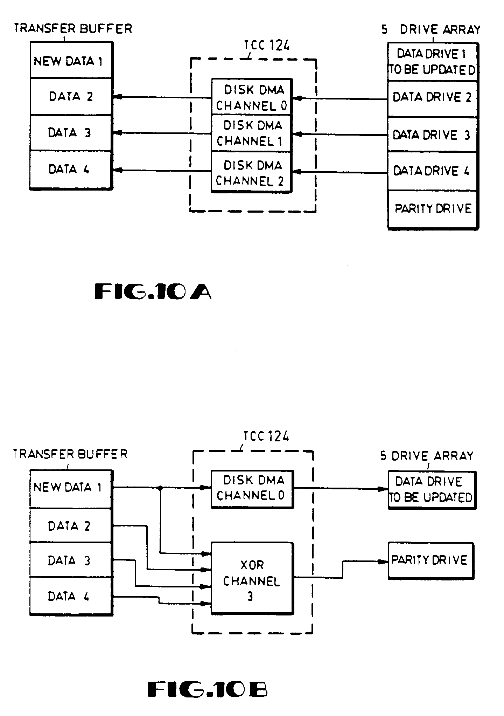

Figure 10 is a schematic block diagram showing the process by which the parity engine may be used to maintain a disk drive array having four data drives and one parity drive within the array. The operation in Figure 10 depicts the writing of new data contained within the transfer buffer to one drive in the five drive array. In step 1, the local processor 122 programs TCC 124 to have disk DMA channels 0-2 read data from the three data drives not being updated and place this information in the transfer buffer. In step 2 the parity control register enables the XOR engine and allocates subchannel 3 to create parity information and reads the data contained in the new data transfer buffer as well as the data which had been previously written from data drives 2-4. The new data is written through disk DMA channel 0 to disk number 1 which is to be updated. The same information as well as the data contained within data blocks 2-4 is read by the XOR channel and parity information generated. The parity information written to the parity drive within the five drive array.

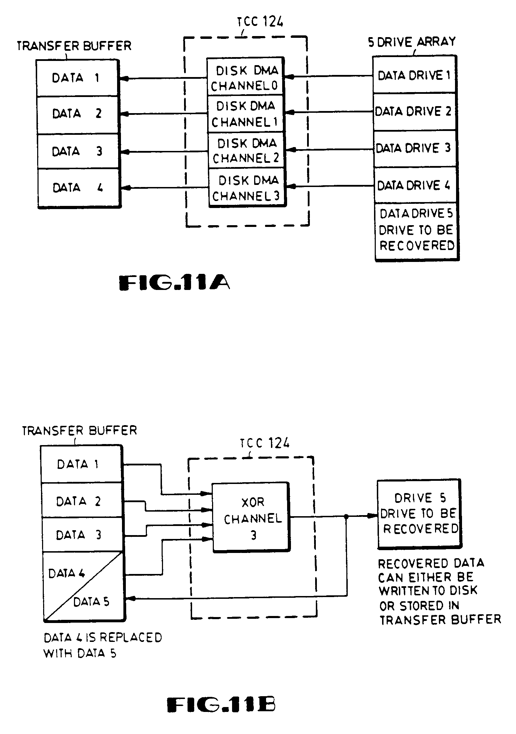

Figure 11 is a schematic block diagram depicting a manner in which the present invention may be used to recover a drive under parity fault tolerance mode. In step 1 a five drive array is depicted with data drive 5 as the faulty drive array. In step 1, the local processor 122 upon receiving the recovery command instructs the TCC 124 to read data from drives 1-4 over disk DMA channels 0-3. It should be noted that in this instance, disk DMA subchannel 3 is not enabled to act as a parity channel but instead to operate as a disk DMA channel. The data from drives 1-4 is loaded into transfer buffer blocks. In step 2, the vocal processor 122 instructs the TCC 124 to read the data from transfer buffer blocks 1-4 through disk DMA channel 3which has now been enabled to act as the XOR parity channel, so that the XOR engine may generate parity information. The data generated by the parity XOR engine may be written to drive or may be written back to the transfer buffer. This data is the recovered data if the drive 5 was not the parity drive. If the failed drive was the parity drive, the data is the regenerated parity information.

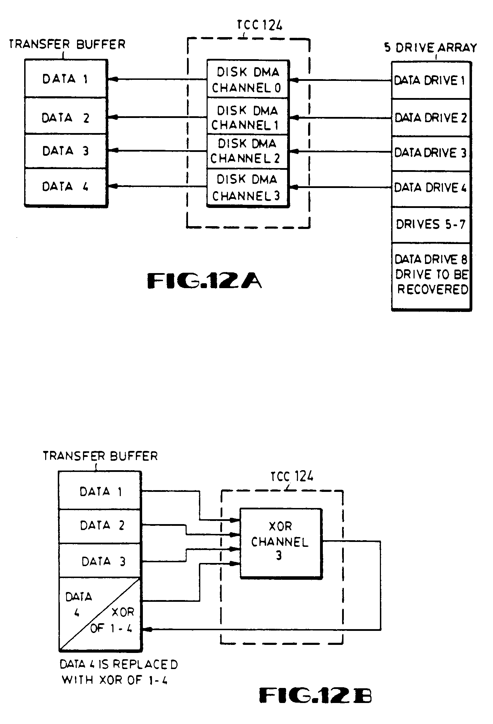

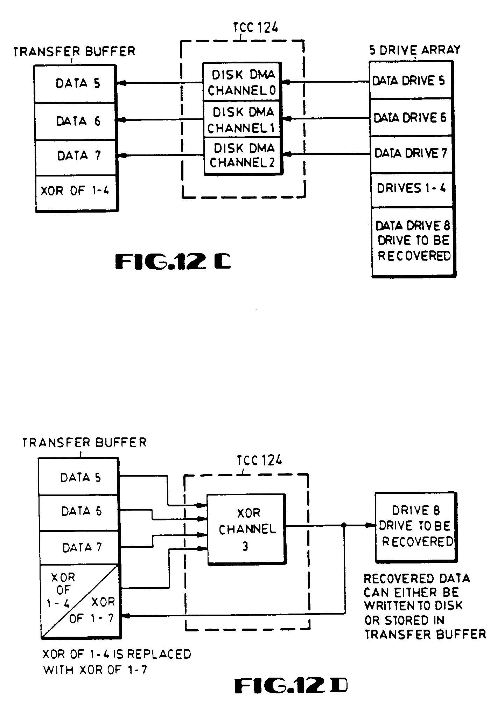

Figure 12 is a schematic block diagram showing the method by which the XOR engine incorporated in the present invention may be used to recover data information in an 8 drive array. In step 1, upon receiving a recover instruction, the local processor 122 instructs the TCC 124 to read data drives 1-4 over disk DMA channels 0-3 and the information is stored in transfer buffer blocks as data 1-4. In step 2 the local processor 122 instructs the TCC 124 to read transfer buffer data blocks 1-4 over XOR channel 3 which is now been enabled to generate parity information. The parity information is written back to data block 4 as the results of the XOR of data contained within transfer buffer blocks 1-4. In step 3, the local processor 122 instructs the TCC 124 to read the data from drives 5-7 over disk DMA channels 0-2 and places the information in transfer blocks as data 5, 6 and 7. In step 4 the local processor 122 instructs the TCC 124 to read the transfer buffer blocks containing data 5-7 and the XOR of 1-4 over XOR parity channel 3 which has now been enabled to output parity information. The former XORd data may be written to drive 8 as a recovered drive data or may be written back to the transfer buffer as the results of the XOR of drives 1-7.

The method of the present invention calls for the use of information written to reserved sectors on each disk within the disk array. The reserved information sectors ("RIS") include information which relate to the individual drives, the drive array in its entirety and individual drive status. These RIS parameters include individual drive parameters such as: the number of heads for a particular drive; the number of bytes per track for a drive; the number of bytes per sector for a drive; and the number of sectors per track for a drive and the number of cylinders. On a more global level, RIS information will include the particular drive I.D.; the configuration signature; the RIS revision level; the drive configuration; the physical number of drives which make up the logical unit; the number of drives which make up the logical drive; and the drive state for a particular drive. The configuration signature is an information field generated by the EISA configuration utility which identifies the particular configuration. The RIS data also includes information which applies to the logical drive in its entirety as opposed to individual drives. This type of information includes the particular volume state; a compatibility port address; the type of operating system being used; the disk interleave scheme being used; the fault tolerance mode being utilized; and the number of drives which are actually available to the user, as well as logical physical parameters, including cylinder, heads, etc. The disk array controller 42 incorporating the present invention maintains GLOBAL RIS information, which applies to all disks within the logical unit as a data structure in local RAM memory 128. The RIS data is utilized for purposes of configuring the disk array as well as management of fault tolerance information.

Figures 4A and 48 are flow diagrams of the method utilized by the present invention to load a configuration for a particular disk array. A disk array configuration signature is created by the EISA configuration utility (see Appendix 1) and stored in system CMOS memory. Upon power up of the computer system, the system processor 20 sets a pointer to the disk configuration signature in host system CMOS memory and sends the configuration signature to the local processor 122 via the BMIC 118. The local processor 122 then builds a configuration based on information within the logical drive RIS sectors and verifies the validity the disk configuration via the configuration signature. If one or more of the drives are replacements, the disk controller 112 will mark the disk as not configured and proceed to configure the remainder of the drive in the logical unit. If all of the drives are consistent, the GLOBAL RIS will be created. If all the drives are not consistent, the present invention will VOTE as to which of the RIS data structures is to be used as a template. The EISA CMOS issues a command to start recovery upon being notified of a replacement disk, which will initiate the RECONSTRUCT module to rebuild the disk. Once the disk has been rebuilt, it will be activated.

If the local processor 122 is unable to build a configuration due to a conflicting configuration signature, the local processor 122 will set an error flag which will notify the system processor 20 to run the EISA configuration utility.

Operation begins at step 400. In step 402 the local processor 122 determines whether there is an existing global RIS. In step 406 the local processor 122 determines whether the first physical drive in the array is present. In determining whether a disk drive is present, the local processor 122 will attempt to write to specific sectors on the drive and read them back. If the drive is not present the attempted read will result in an error condition indicating that the physical drive is not present. If the first drive is not physically present, control transfers to step 406 wherein the local processor 122 since the present flag within the data structure allocated for the drive to false and sets the RIS data structure to null. Control transfers to step 408. If in step 406 it is determined that drive I is present, control transfers to step 410 wherein the local processor 122 sets the present flag within the data structure allocated to the disk equal to true and reads the RIS sectors from the drive and loads them into the local data structure. Control transfers to step 412. In step 412 the local processor 122 determines if there are additional drives within the array. If yes, the local processor 122 advances to the next drive within the drive map and control returns to step 406. If no, the local processor determines whether the RIS sectors for the drives present in the array are valid. This is accomplished by the local processor 122 reading disk parameters from the RIS sectors and determining whether the RIS parameters are valid for the drives installed within the array. Control transfers to step 416 wherein the local processor 122 determines if there is at least one valid RIS structure among the disk within the array. If no, control transfers to step 418 wherein the local processor 122 sets an error code and control returns to the calling program in step 420. If it is determined in step 416 that there exist at least one valid RIS structure within the disk in the array, control transfers to step 422 wherein the local processor 122 call function ALL-CONSISTENT to determine if the RIS sectors for the drives within the array are consistent among themselves. Control transfers to step 424. In step 424 the local processor 122 determines whether all drives have consistent RIS data. If no, control transfers to step 426 wherein the local processor 122 calls function VOTE to determine the proper configuration to be utilized as a template. Control transfers to step 428 wherein the local processor 122 invalidates any RIS data structures which are not consistent with the results of VOTE. Control transfers to step 430.

If in step 424 it is determined that all drives are consistent, control transfers to step 430. In step 430, the local processor 122 determines whether all drives have a unique drive I.D. If the drives do not have unique drive I.D.'s, control transfers to step 432 wherein the local processor 122 sets the GLOBAL RIS data structure to null value and control transfers to step 434. In step 430, the local processor 122 determines that all drives have a unique I.D., control transfers to step 434. In step 434, the local processor determines whether the drive being addressed matches its position in the drive map as determined by the GLOBAL RIS. This would indicate whether a particular drive within the array has been moved with respect to its physical location within the array. If the drives do not match the position within the drive map, control transfers to step 436 wherein the local processor 122 sets the GLOBAL RIS data structure to NULL. Control transfers to step 438. If it is determined in step 434 that the drives match their position within the drive map, control transfers to step 438 wherein the local processor determines whether a disk has RIS data but a non-valid RIS. If the particular disk has RIS data but non-valid RIS data, control transfers to step 440 wherein the local processor 122 sets the drive status flag to indicate that the drive is a replacement drive. Control transfers to step 442. If it is determined in step 438 that the disk does not have data and non-valid RIS structure, control transfers to step 442. Steps 430-440 are used to test each drive within the drive array. In step 442 the local processor 122 allocates local memory for a new GLOBAL RIS data structure. Control transfers to step 444 wherein the local processor 122 copies RIS data structure from either the consistent configuration or the template as determined by VOTE. Control transfers to step 446 wherein the local processor releases local RIS data structure memory, and writes the new GLOBAL RIS to all drives within the array. Control transfers to step 448 which terminates operation of the current function.

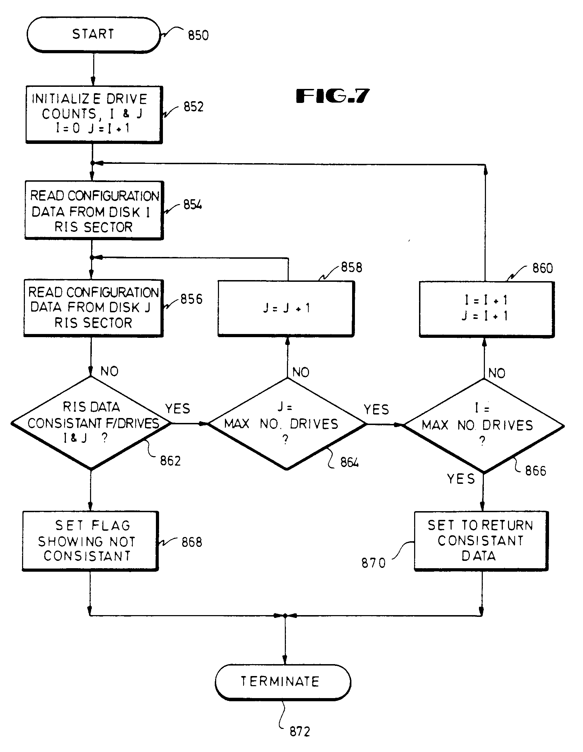

Figure 7 is a flow diagram of the manner in which the present invention determines whether all RIS sectors for disks within the array are consistent. In determining whether all drives are consistent, the local processor 122 will read the RIS sectors for the first drive in the drive map and compare the information therein with the corresponding RIS sectors for the second, third, etc. drives until it has compared the first disk to all others in the array. The local processor 122 will advance to the second drive and compare its RIS sectors with all subsequent drives in the array. This will continue until it is determined that all drives are consistent or the module determines an inconsistency exists. Operation begins at step 850. Control transfers to step 852 wherein the local processor 122 initializes drive count variables. Control transfers to step 854 wherein the local processor 122 reads the configuration data from a disk RIS sector (Drive I). Control transfers to step 856 wherein the local processor reads the configuration data from the RIS sector of the next disk in the drive map (Drive J). Control transfers to step 862 wherein the local processor 122 determines whether the RIS data for the two drives I and J are consistent. If not consistent, control transfers to step 868 which sets a flag indicating that the drives are not consistent. Control thereafter transfers to step 872 which returns to the calling program. If the RIS data is consistent for drives I and J, control transfers to step 864 wherein the local processor 122 determines whether J is equal to the maximum number of drives the array. If not equal to the maximum number of drives in the array, control transfers to step 858 which increments the J counter and control thereafter transfers to step 856 in this manner the program will read the first disk and compare RIS data from the first disk with the RIS data from all other drives. If J is equal to the maximum number of drives, control transfers to step 866 wherein the local processor 122 determines whether I is equal to the maximum number of drives in the disk array. If I is not equal to the maximum number of drives in the disk array, control transfers to step 860 wherein I is set equal to I + 1 and J is equal to I + 1. Control transfers to step 854. If I is equal to the maximum number of drives, control transfers to step 870 which sets a flag indicating that all RIS disk sectors are consistent. Control transfers to step 872 which returns to the calling program.

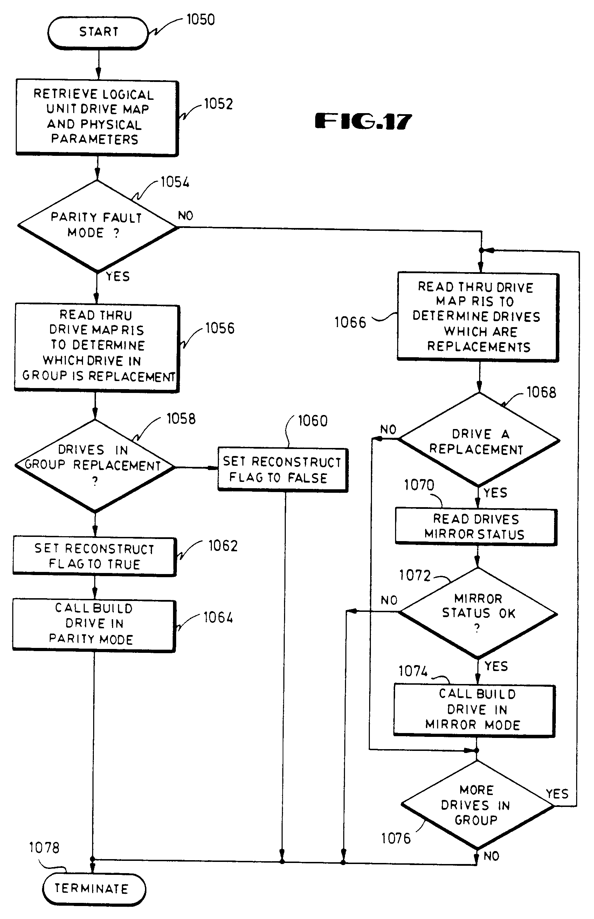

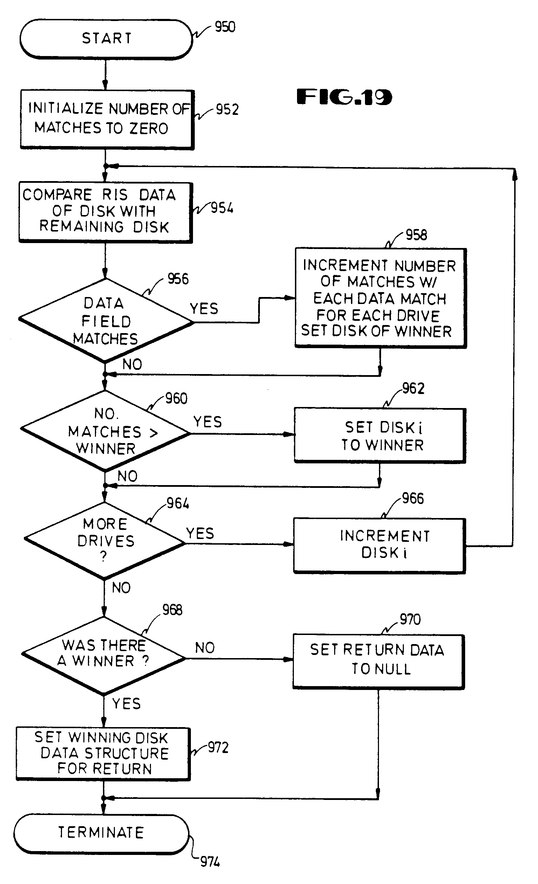

Figure 19 is a flow diagram of the VOTE function by which the present invention determines which of any number of valid RIS configurations which may exist on a disk is to be used as a templet for configuring the entire disk array. Operation begins at step 950. Control transfers to step 952 which initializes the winner to NULL and the number of matches to 0. Control transfers to step 954 wherein the local processor 122 compares the RIS data for the current disk (Disk I) with all remaining disks. Control transfers to step 956 wherein the local processor 122 determines whether the data field within the RIS structure for disk I matches the corresponding data fields in the remaining disk RIS structures. If a match exists, control transfers to step 958 which increments the number of matches with which each data match for each drive within the disk array. Upon finding the first match, the first drive is declared a temporary winner. Control transfers to step 960.

If there are no further data field matches in step 956, control transfers to step 960 wherein the local processor 122 determines whether the number of matches for the current disk being examined exceeds the number of matches determined for the disk currently designated as a winner. If yes, control transfers to step 962 which sets the current disk equal to the winner. Control transfers to step 964. In step 964 the local processor 122 determines whether there are additional drives to be examined in voting. If yes, control transfers to step 966 which increments the current disk to the next disk within the array. Control transfers to step 954.

The local processor will continue to loop between step 954 and 964 until all drives have been examined field by field and the drive with the most data matches is designated as a winner or in the case of no matches in the RIS sector of the disk there is no winner. If in step 964 it is determined there are no further drives in the array, control transfers to step 968 wherein the local processor determines whether there has been a winner. If there is no winner, control transfers to step 970 which sets a return data to null. Control then transfers to step 974 which returns to the calling program. If in step 968 the local processor 122 is determined that there is a winner, control transfers to step 972 wherein the winning disk data structure is flagged as the data structure template for return. Control transfers to step 974 which returns to the calling program.

The next set of modules are directed toward the detection of a replacement disk within an array and the regeneration of data. The present invention will initiate the rebuild request only if (1) the mirror or parity fault tolerance mode is active and (2) a read command has failed. If neither of these fault tolerance modes are active, the drive may be regenerated by restoring from a backup medium. A mirroring or parity fault will be detected when a physical request to read a specific block of data from any one of the drives within the disk array system returns a read failure code. The regeneration process presumes that both of these conditions are true. As indicated in the command protocol section, the system processor must issue a start recovery command to begin the rebuild process.

The following flow diagrams depict the method of rebuilding a disk which has been inserted as a replacement disk in a disk array system. The discussion presumes that a start recovery command has been received and acted upon by the local processor 122. The disk array controller 112 has the capacity to run a disk array check program. In module RECONSTRUCT, the local processor 122 will detect the presence of a replacement drive by reading the drive status from RIS sectors on each drive within the array and determine the fault tolerance mode in use in the array. If a replacement drive has been installed in the array, an attempt to read the RIS sectors on the drive will result in a faulty read, as the replacement drive will not have the RIS sectors. The local processor 122 will then call module BUILD_DRIVE.

The local processor 122 in the BUILD_DRIVE module creates a series of read requests for every sector on the replacement drive, based upon the information contained within the GLOBAL RIS structure. The read requests are executed, each returning a null read, indicating a failed read. The local processor 122 while running BUILD_DRIVE calls the REGENERATE module which determines the nature of the tolerance mode and instructs the local processor 122 to build a recovery command for each failed read request. The method of building the recovery command is set forth in modules MIRROR_REGEN and PARITY_REGEN are generally known in the art. The BUILD_DRIVE module then returns control of the local processor 122 to the RECONSTRUCT module. The RECONSTRUCT module then converts each failed read request to a write/rebuild request and links them to a recovery request header. The recovery request header and write/rebuild requests are then scheduled for execution by the disk array controller.

In this manner, the disk array controller is solely responsible for managing the rebuilding of the replacement disk. The system processor is not involved in the determination that the drive is a replacement or the generation and execution of the rebuild commands. Accordingly, the rebuild of the replacement disk is virtually transparent to the computer system.

Figure 17 is a flow diagram of the RECONSTRUCT function which is utilized to control the process of reconstructing data into a newly replaced drive in the array when a fault tolerance mode is active. Operation begins at step 1050. Control transfers to step 1052 wherein the local processor 122 retrieves logical unit drive map and physical parameters. Control transfers to step 1054 wherein the local processor 122 determines whether the drive group is in a PARITY_FAULT mode. If in a PARITY_FAULT mode, control transfers to step 1056 wherein the local processor 122 reads through all drive group RIS sectors to determine from the drive status which of the drives within the group is a replacement drive. Control transfers to step 1058. An attempted read of a replacement drive will result in a null read, as the RIS structure will not exist on the replacement disk thus, a null read indicates the existence of a replacement drive. If the local processor 122 fails to determine that any one of the drives within the drive group is a replacement, control transfers to step 1060 which sets a reconstruction flag to FALSE. Control then transfers to step 1078 which returns to the calling program. If it is determined in step 1058 that there is one drive which is a replacement by way of the null read, control transfers to step 1062 where the local processor 122 sets a reconstruct flag equal to TRUE. Control transfers to step 1064 wherein the local processor 122 calls the BUILD_DRIVE function. Control transfers to step 1078 which returns to the calling program. If it is determined that in step 1054 that the PARITY_FAULT mode is not active, control transfers to step 1066 where the local processor 122 reads through the RIS sectors for disks within the group to determine which of the drives are replacements by way of a null read. Control transfers to step 1068 wherein the local processor 122 determines whether a particular drive is a replacement. If yes, control transfers to step 1070 wherein the local processor 122 reads the drive's mirror drive status. Control transfers to step 1072 wherein the local processor 122 determines whether the current drive's mirror drive status is valid. If yes, control transfers to step 1074 in which the local processor 122 calls function BUILD_DRIVE. Control transfers to step 1076 wherein the local processor 122 determines whether there are additional drives within the particular drive group. Control then transfers to step 1066. If it is determined in step 1068 that the current drive is not a replacement, control transfers to step 1076. If it is determined in step 1072 that the current faulty drive's mirror drive status is not valid, control transfers to step 1078 which returns to the calling program. If it is determined in step 1076 that there are no additional drives in the group, control transfers to step 1078 which returns to the calling program.

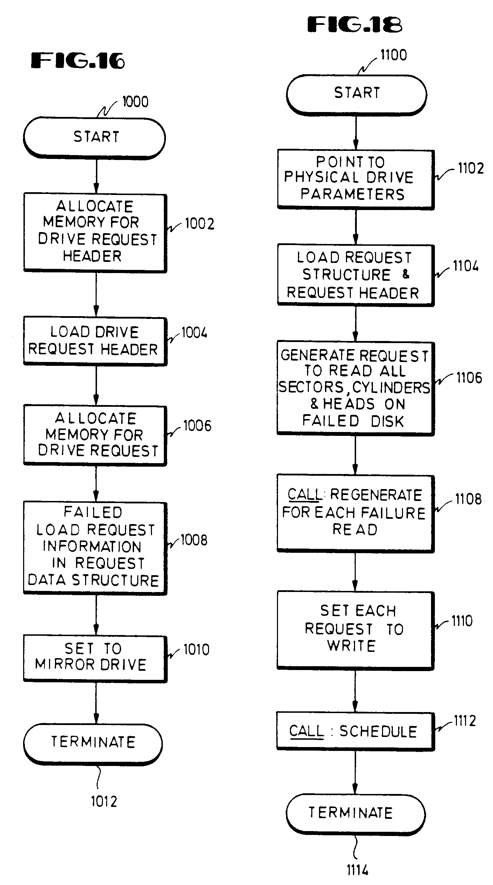

Figure 18 is a flow diagram of the method utilized in the BUILD_DRIVE function. Operation begins at step 1100. Control transfers to step 1102 wherein the local processor 122 sets pointers to the physical drive parameters for the failed request. Control transfers to step 1104 wherein the local processor 122 allocates memory for and loads the request structure and request header. Control transfers to step 1106 wherein the local processor 122 builds commands to read all sectors, cylinders and heads on the replacement disk. Each one of the attempted reads will create a failure as the drive is a replacement and will not contain the information sought by the request. Control transfers to step 1108 which calls the REGENERATE function for each failed read. Control transfers to step 1110 wherein the local processor 122 sets each of the failed read requests to a write command. Control transfers to step 1112 wherein the local processor 122 schedules the write commands to be operated upon by the disk array controller. Control transfers to step 1114 which terminates operation of the program.

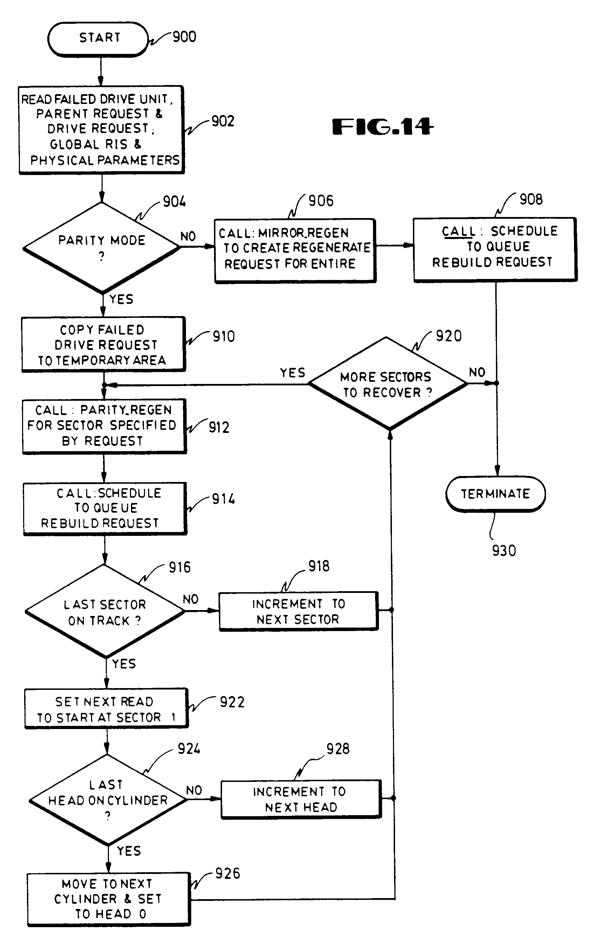

Figure 14 is a flow diagram of the REGENERATE function used to regenerate the data from a failed drive using data from other drives in the logical unit when either mirror or parity mode is active. Operation of this function begins at step 900. As REGENERATE is called by BUILD_DRIVE and, ultimately, RECONSTRUCT, it will only operate if there is a mirror or parity fault tolerance mode active. Further, the failed request must have been a read request. This information will be transferred with a drive request which has failed. Control transfers to step 902 wherein the local processor 122 reads the failed drive unit RIS sectors, drive request and parent request. Further, the local processor obtains physical parameters of the disk from the GLOBAL RIS information from an image maintained in local memory. Control transfers to step 904 wherein the local processor 122 determines whether the drive group is in a PARITY_FAULT mode. If yes, control transfers to step 910 wherein the local processor 122 copies the failed drive request to a temporary area. Control transfers to step 912 wherein the local processor 122 calls function PARINREGEN for the first disk sector specified in the request. Control transfers to step 914 wherein the local processor 122 places the rebuild request in a low level queue designed to ignore prohibitions on I/O operations to replacement drives which has returned from the PARITY_REGEN function. Control transfers to step 916 wherein the local processor 122 determines whether the sector associated with the particular request is the last sector on the track of the disk. If not the last sector on the track, control transfers to step 918 wherein the local processor 122 increments to the next sector on the track. Control transfers to step 920 wherein the local processor 122 determines whether there are additional sectors associated with the failed request to be recovered. If not, control transfers to step 930 which terminates operation of the REGENERATE function. If yes, control transfers to step 912.

If in step 916 it is determined that the sector associated with the particular request is the last sector on the disk track, control transfers to step 922 wherein the local processor 122 sets the next read to start at sector 1. Control transfers to step 924 wherein the local processor 122 determines whether the current head is the last head on the cylinder. If the current head is the last head on the cylinder, control transfers to step 926 wherein the local processor 122 sets the pointers to the next cylinder and set the selected head to 0 (the first head for that cylinder). Control transfers to step 920. If it is determined in step 924 that the current head is not the last head on the cylinder, control transfers to step 928, wherein the local processor 122 increments the current head value to the next head on the cylinder. Control transfers to step 920.

If in step 904 it is determined that the PARITY_FAULT mode is not active, control transfers to step 906 wherein the local processor 122 calls the function MIRROR_REGEN to create a regenerate request for the entire failed request as opposed to a sector by sector request as carried out in the PARITY_FAULT mode. Control transfers to step 908 wherein the local processor 122 places the requests in a low level queue designed to ignore drive state prohibitions against I/O operations to replacement disks. Control transfers to step 930 which terminates the operation of the regenerate function.

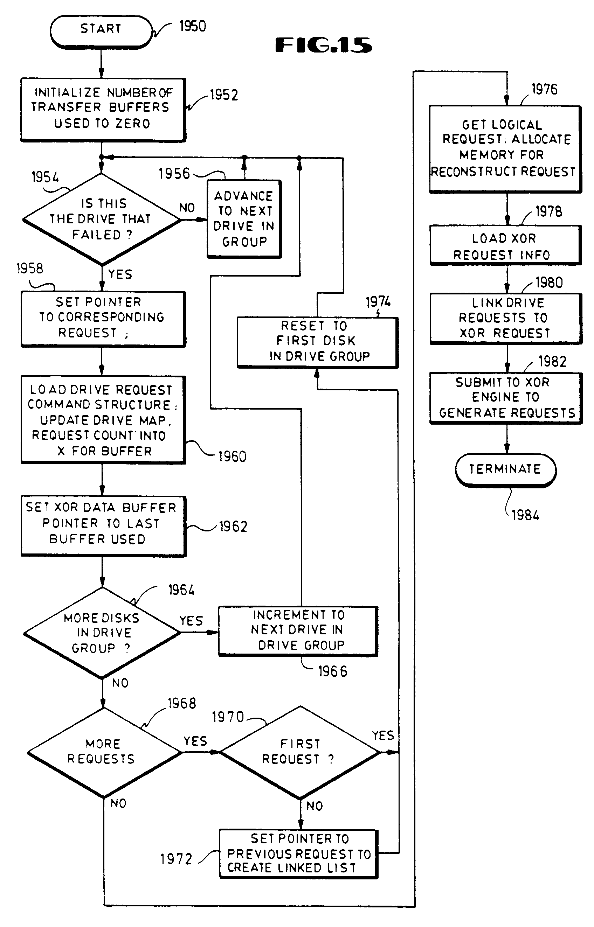

Figure 15 is a flow diagram of the PARITY_REGEN function which builds the rebuild commands for a parity fault tolerant array. Operation begins at step 1950. Control transfers to step 1952 which initializes the number of transfer buffers utilized to 0. Control transfers to step 1954 wherein the local processor 122 reads the drive map and determines whether the current drive is the drive which has failed. If it is determined that the current drive is not the drive which has failed, control transfers to step 1956 wherein the local processor advances the drive index to the next drive within the drive group and control transfers to step 1954. If it is determined in step 1954 that the current drive is the drive which has failed, control transfers to step 1958 wherein the local processor 122 sets a pointer to the corresponding request which has failed. Control transfers to step 1960 wherein the local processor 122 loads the drive request command structure with the parent logical request, position in drive map and command type. The local processor 122 also loads the request into the transfer buffer and updates the global RIS drive map in the local processor memory. Control transfers to step 1962 wherein XOR data buffer pointer is set to the last buffer utilized. Control transfers to step 1964 which determines whether there are additional disks in the drive group. If yes, control transfers to step 1966 wherein the local processor 122 advances the drive map index to the next drive in the drive group. If there are no further disks in the drive group, control transfers to step 1968 in which the local processor 122 determines whether there are additional requests associated with the current drive request. If yes, control transfers to step 1970. In step 1970 the local processor 122 determines whether the current request is the first drive request associated with the failed read request. If yes, control transfers to step 1974. If not, control transfers to step 1972 wherein the local processor 122 sets the current request pointer is set to the previous request to create a linked list of requests and control transfers to step 1974. In step 1974 the local processor 122 resets the drive map index to the first disk in the drive group. Control transfers to step 1954. If in step 1968 it is determined there are no further requests associated with the failed drive request, control transfers to step 1976 wherein the local processor 122 obtains logical request information and allocates memory for the XOR request. Control transfers to step 1978 wherein the local processor loads the xoRrequest information into the data structure. Control transfers to step 1980 wherein the linked drive requests are linked to the XOR request. Control transfers to step 1982 which submits the XOR request header followed by the linked list of drive request to the parity XOR engine to generate individual requests. Control transfers to step 1984 which returns all of the requests to the calling program.

Figure 16 is a flow diagram of the MIRROR_REGEN function which generates rebuild commands for a disk array in mirror fault tolerance mode. Operation begins at step 1000. Control transfers to step 1002 wherein the local processor 122 allocates memory for the drive request header. Control transfers to step 1004 wherein the local processor 122 loads the drive request header from information in the logical request and the failed request. Control transfers to step 1006 which allocates memory for the individual drive request. Control transfers to step 1008 which loads the failed request information into the request data structure. Control transfers to step 1010 which sets the request to read from the mirror drive and write to the failed drive. Control transfers to step 1012 which returns to the calling program.

The present invention provides for a means of reconstructing a replacement drive within a fault tolerant, intelligent disk array system. The present invention is capable of detecting a new disk in an array and creating and scheduling commands necessary to rebuild the data for the replacement disk in background mode without intervention by the system processor or suspension of normal system operations. Thus, the reconstruction of a disk is virtually transparent to the user.

## Claims

1. A method for use with a computer system (C) having a fault tolerant, intelligent mass storage disk array subsystem (112, 114, 116), the disk array subsystem (112, 114, 116) having a microprocessor based controller (112), for rebuilding a replacement disk drive within the array (116) without system processor (20) supervision or suspension of system operations, executing the following steps under the control of said disk subsystem controller (112):
a) reading disk array and disk drive status information and fault tolerance mode for the disk array (116) from reserved sectors on all disk drives within the drive array (116) to determine if one or more of the drives in the array (116) has been replaced;
b) reading all sectors on the replacement drive, thereby causing a failed sector read to occur when attempting to read the replacement drive sectors, indicating a sector to be restored;
c) generating rebuild commands for the replacement disk by writing to each failed sector utilizing the active fault tolerance mode;
d) queuing the rebuild commands; and
e) executing the rebuild commands by the microprocessor based controller (112) independent of the computer system processor (20), thereby restoring data to the replacement disk drive.

2. The method of claim 1, wherein the step of determining if one or more of the disk drives in the disk array (116) is a replacement drive includes running a drive array check program by the microprocessor based controller (112) at each computer system power-up.

3. The method of claim 1, wherein the step of determining if one or more of the disk drives in the disk array (116) is a replacement drive includes running a drive array check program at periodic intervals by the microprocessor based controller (112).

4. The method of claim 2 or 3, wherein the step of determining if one or more of the disk drives in the disk array (116) is a replacement drive includes comparing individual disk drive information to a disk array configuration template maintained by the microprocessor based controller (112).

5. The method of any of claims 1 to 4, wherein the step of reading all sectors on the replaced drive includes creating an information packet for each sector on the drive, the information packet including drive array and disk drive information from a disk array configuration template, a read command and physical drive parameters indicating the location of the sector to be read.

6. The method of claim 5, wherein the step of generating rebuild commands includes:
creating a rebuild header command, including information from the drive array (116) and disk drive configuration template, the fault tolerance mode and instructions to activate the fault recovery mode;
changing the read command for each sector in the replacement drive to a write command; and
linking all of the write commands to the rebuild command header.

7. The method of any of claims 1 to 6, wherein the method of restoring data to the replacement disk drive includes writing the restored data to the replacement disk from a mirror data disk.

8. The method of any of claims 1 to 6, wherein the method of restoring data to the replacement disk drive includes, generating the restored data utilizing an XOR parity technique from data on the remaining disks within the array (116).

9. The method of claim 8, wherein the method of generating the restored data includes generating the restored data utilizing a dedicated XOR parity engine within the disk array subsystem (112, 114, 116).

## Patentansprüche

1. Verfahren zur Verwendung bei einem Rechnersystem (C), welches ein störungstolerantes, intelligentes Massenspeicher-Plattenarray-Subsystem (112, 114, 116) aufweist, welches eine mikroprozessorgestützte Steuerung (112) für den Einbau eines Ersatz-Plattenlaufwerks in das Array (116) ohne Überwachung durch den Systemprozessor (20) oder Aussetzung von Systemoperationen aufweist, wobei folgende Schritte unter der Steuerung seitens der Plattensubsystemsteuerung (112) ausgeführt werden:
a) Lesen von Plattenarray und Plattenlaufwerk-Statusinformation und eines Störungstoleranzmodus für das Plattenarray (116) aus reservierten Sektoren sämtlicher Plattenlaufwerke innerhalb des Laufwerkarrays (116), um festzustellen, ob ein oder mehrere Laufwerke in dem Array (116) ausgetauscht wurden;
b) Lesen sämtlicher Sektoren auf dem Ersatz-Laufwerk, um dadurch zu veranlassen, dass es bei dem Versuch, Ersatzlaufwerk-Sektoren zu lesen, zu einem gestörten Sektor-Lesevorgang kommt, was einen wiederherzustellenden Sektor anzeigt;
c) Generieren von Erneuerungsbefehlen für die Ersatzplatte durch Einschreiben in jeden gestörten Sektor unter Verwendung des aktiven Störungstoleranzmodus;
d) Stellen der Erneuerungsbefehle in eine Warteschlange; und
e) Ausführen der Erneuerungsbefehle durch die Mikroprozessorgestützte Steuerung (112) unabhängig von dem Rechnersystem-Prozessor (20), um dadurch Daten für das Ersatz-Platterlaufwerk wieder herzustellen.

2. Verfahren nach Anspruch 1, bei dem der Schritt des Ermittelns, ob eines oder mehrere der Plattenlaufwerke innerhalb des Plattenarrays (116) ein Ersatzlaufwerk ist, die Durchführung eines Laufwerkarray-Prüfprogramms durch die mikroprozessorgestützte Steuerung (112) bei jeder Rechner-Netzeinschaltung beinhaltet.

3. Verfahren nach Anspruch 1, bei dem der Schritt des Ermittelns, ob ein oder mehrere Plattenlaufwerke innerhalb des Plattenarrays (116) ein Ersatzlaufwerk ist, die Durchführung eines Laufwerkarray-Prüfprogramms in periodischen Intervallen durch die Mikroprozessorgestützte Steuerung (110) beinhaltet.

4. Verfahren nach Anspruch 2 oder 3, bei dem der Schritt des Ermittelns, ob ein oder mehrere der Plattenlaufwerke innerhalb des Plattenarrays (116) ein Ersatzlaufwerk ist, das Vergleichen individueller Plattenlaufwerksinformation mit einer Plattenarray-Konfigurationsschablone beinhaltet, die von der mikroprozessorgestützten Steuerung (112) geführt wird.

5. Verfahren nach einem der Ansprüche 1 bis 4, bei dem der Schritt des Lesens sämtlicher Sektoren an dem eingetauschten Laufwerk die Erzeugung eines Informationspakets für jeden Sektor des Laufwerks beinhaltet, wobei das Informationspaket Information über Laufwerkarray und Plattenlaufwerk von einer Plattenarray-Konfigurationstabelle, einen Lesebefehl und Parameter für reale Laufwerke, welche die Lage des zu lesenden Sektors angeben, beinhaltet.

6. Verfahren nach Anspruch 5, bei dem der Schritt des Erzeugens von Erneuerungsbefehlen beinhaltet:
Erzeugen eines Erneuerungsvorsatzbefehls, beinhaltend Information von dem Laufwerkarray (116) und der Plattenlaufwerk-Konfigurationsschablone, dem Störungstoleranzmodus und Instruktionen zum Aktivieren des Störungsbehebungsmodus;
Ändern des Lesebefehls für jeden Sektor in dem Ersatzlaufwerk in einen Schreibbefehl; und
Verknüpfen sämtlicher Schreibbefehle mit dem Erneuerungsbefehlsvorsatz.

7. Verfahren nach Anspruch 6, bei dem das Verfahren zur Wiedergewinnung von Daten für das Ersatz-Platterlaufwerk das Schreiben der wieder gewonnenen Daten aus einer Spiegeldatenplatte auf die Ersatzplatte beinhaltet.

8. Verfahren nach einem der Ansprüche 1 bis 6, bei dem das Verfahren der Wiederherstellung von Daten für das Ersatz-Plattenlaufwerk beinhaltet, das die wieder gewonnenen Daten unter Verwendung einer XOR-Paritätsmethode aus Daten der verbleibenden Platten innerhalb des Arrays (116) generiert werden.

9. Verfahren nach Anspruch 8, bei dem das Verfahren zum Generieren der wieder hergestellten Daten das Generieren der wieder hergestellten Daten unter Verwendung einer Spezial-XOR-Paritätsmaschine innerhalb des Plattenarray-Subsystems (112, 114, 116) beinhaltet.

## Revendications

1. Un procédé pour l'utilisation avec un système informatique (C) ayant un sous-système de réseau de disques de mémoire de masse intelligent (112, 114, 116), le sous-système de réseau de disques (112, 114, 116) ayant un contrôleur (112) basé sur un microprocesseur, pour reconstruire un lecteur de disque de remplacement dans le réseau (116), sans supervision par le processeur de système (20) ni suspension des opérations du système, exécutant les étapes suivantes sous la commande de ce contrôleur de sous-système de disques (112) :
a) la lecture d'une information d'état de réseau de disques et de lecteurs de disques, et d'un mode de tolérance de défauts pour le réseau de disques (116), à partir de secteurs réservés sur tous les lecteurs de disques dans le réseau de disques (116), pour déterminer si un ou plusieurs des lecteurs dans le réseau (116) ont été remplacés;
b) la lecture de tous les secteurs sur le lecteur de remplacement, pour ainsi faire en sorte qu'une lecture de secteur défectueux ait lieu lors d'une tentative de lecture des secteurs du lecteur de remplacement, indiquant un secteur à restaurer;
c) la génération d'ordres de reconstruction pour le disque de remplacement, en écrivant dans chaque secteur défectueux en utilisant le mode de tolérance de défauts actif;
d) la mise en file d'attente des ordres de reconstruction; et
e) l'exécution des ordres de reconstruction par le contrôleur (112) basé sur un microprocesseur, indépendamment du processeur (20) du système informatique, pour restaurer ainsi des données dans le lecteur de disque de remplacement.

2. Le procédé de la revendication 1, dans lequel l'étape consistant à déterminer si un ou plusieurs des lecteurs de disques dans le réseau de disques (116) est un lecteur de remplacement comprend l'exécution d'un programme de contrôle de réseau de lecteurs par le contrôleur (112) basé sur un microprocesseur, à chaque mise sous tension du système informatique.

3. Le procédé de la revendication 1, dans lequel l'étape consistant à déterminer si un ou plusieurs des lecteurs de disques dans le réseau de disques (116) est un lecteur de remplacement comprend l'exécution d'un programme de contrôle de réseau de disques à des intervalles périodiques par le contrôleur (112) basé sur un microprocesseur.

4. Le procédé de la revendication 2 ou 3, dans lequel l'étape consistant à déterminer si un ou plusieurs des lecteurs de disques dans le réseau de disques (116) est un lecteur de remplacement comprend la comparaison d'une information de lecteur de disque individuel avec un modèle de configuration de réseau de disques qui est entretenu par le contrôleur (112) basé sur un microprocesseur.

5. Le procédé de l'une quelconque des revendications 1 à 4, dans lequel l'étape de lecture de tous les secteurs sur le lecteur remplacé comprend la création d'un paquet d'information pour chaque secteur sur le lecteur, le paquet d'information contenant une information de réseau de lecteurs et de lecteurs de disques provenant d'un modèle de configuration de réseau de disques, un ordre de lecture et des paramètres de lecteur physique indiquant l'emplacement du secteur à lire.

6. Le procédé de la revendication 5, dans lequel l'étape de génération d'ordres de reconstruction comprend :
la création d'un ordre d'en-tête de reconstruction, comprenant une information provenant du modèle de configuration de réseau de disques (116) et de lecteurs de disques, le mode de tolérance de défauts et des instructions pour activer le mode de reprise sur défaut;
le changement de l'ordre de lecture pour chaque secteur dans le lecteur de remplacement, pour qu'il devienne un ordre d'écriture; et
l'enchaînement de tous les ordres d'écriture à l'en-tête d'ordre de reconstruction.

7. Le procédé de l'une quelconque des revendications 1 à 6, dans lequel le procédé de restauration de données sur le lecteur de disque de remplacement comprend l'écriture des données restaurées sur le disque de remplacement, à partir d'un disque de données miroir.

8. Le procédé de l'une quelconque des revendications 1 à 6, dans lequel le procédé de restauration des données sur le lecteur de disque de remplacement comprend la génération des données restaurées en utilisant une technique de parité OU-EXCLUSIF, à partir de données sur les disques restants dans le réseau (116).

9. Le procédé de la revendication 8, dans lequel le procédé de génération des données restaurées comprend la génération des données restaurées en utilisant un moteur de parité OU-EXCLUSUF spécialisé, dans le sous-système de réseau de disques (112, 114, 116).
